# EUROPEAN PATENT APPLICATION

(11) **EP 4 610 724 A1**
(43) Date of publication of application: **03.09.2025**
(21) Application number: 23882319.9
(22) Date of filing: 27.09.2023
(51) Int. Cl.: G03F 1/62, G01N 21/894

(54) **INSPECTION DEVICE, INSPECTION METHOD, AND INSPECTION PROGRAM**

(30) Priority: 25.10.2022 JP 2022170415
(71) Applicant: HORIBA, Ltd., Kyoto-shi Kyoto 601-8510 (JP)
(72) Inventor: SOMEYA, Shota, Kyoto-shi, Kyoto 601-8510 (JP); IIDA, Hiroshi, Kyoto-shi, Kyoto 601-8510 (JP); KANZAKI, Toyoki, Kyoto-shi, Kyoto 601-8510 (JP); NAKAGAWA, Kazuya, Kyoto-shi, Kyoto 601-8510 (JP)
(74) Representative: Müller-Boré & Partner Patentanwälte PartG mbB
(86) International application number: PCT/JP2023/035235
(87) International publication number: WO 2024/090109

(57) **Abstract**

Included are a light-emitting unit 2 that irradiates a specimen W having a film-like shape and having optical transparency with the inspection light L1, a scattered light detection unit 3 that detects scattered light L2 from the specimen W, a diffracted light detection unit 4 that detects diffracted light L3 from the specimen W, and a signal processing unit 5 that determines the presence of a contaminant S attached to the specimen W and the presence of a pinhole P formed in the specimen W, on the basis of a scattered light intensity signal from the scattered light detection unit 3 and a diffracted light intensity signal from the diffracted light detection unit 4.

## Description

### Technical Field

The present invention relates to an inspection device, an inspection method, and an inspection program.

### Background Art

As a contaminant inspection device for inspecting for contaminants attached to a film-like specimen such as a pellicle, a contaminant inspection device described in Patent Literature 1 has been developed, for example. This contaminant inspection device detects contaminants attached to a surface of a specimen by projecting light onto the surface of the specimen, and detecting the intensity of the light scattered from the surface.

A film-like specimen such as a pellicle sometimes has a hole (pinhole) penetrating therethrough, from the front surface to the rear surface, and the contaminant inspection device may also be used in detections of such pinholes.

However, with the method of detecting the intensity of light scattered from the specimen, it is difficult to distinguish a contaminant attached to the specimen from a pinhole formed on the specimen.

Therefore, to identify pinholes, separate microscopic observations have been carried out using microscopes disposed on the front and the rear surfaces of the specimen, in addition to the contaminant inspections. In such microscopic observations, both of the front and the rear surfaces of the specimen are observed, and if similar images are observed on both of the surfaces, the object can be identified as a pinhole.

This method of performing separate microscopic observations in addition to the contaminant inspections, however, has a problem that it takes time to carry out the contaminant inspections as well as the pinhole inspections on the specimens.

### Citation List

### Patent Literature

Patent Literature 1: JP 2011-53036 A

### Summary of Invention

### Technical Problem

The present invention has been made in view of the problem described above, and a main object of the present invention is to determine the presence of a contaminant and the presence of a pinhole in an optically transparent film-like specimen, both at once. Solution to Problem

That is, an inspection device according to the present invention includes: a light-emitting unit that irradiates one surface of a specimen having a film-like shape and having optical transparency with inspection light; a scattered light detection unit that is disposed on a side of the one surface of the specimen, the side being a same side as where the light-emitting unit is disposed, and that detects scattered light from the specimen; a diffracted light detection unit that is disposed on a side of another surface of the specimen, the side being on an opposite side of where the light-emitting unit is disposed, and that detects diffracted light from the specimen; and a signal processing unit that determines presence of a contaminant attached to the specimen and presence of a pinhole formed in the specimen, based on a scattered light intensity signal from the scattered light detection unit and a diffracted light intensity signal from the diffracted light detection unit.

With such a contaminant inspection device, it is possible to determine whether there is any contaminant attached to the specimen and there is any pinhole in the specimen, automatically at once, on the basis of the scattered light intensity signal from the scattered light detection unit and the diffracted light intensity signal from the diffracted light detection unit.

Specifically, the presence of a contaminant can be determined by detecting scattered light because, when there is a contaminant attached to the specimen, the contaminant is irradiated with the inspection light and the inspection light becomes scattered as scattered light.

The presence of a pinhole can be determined by detecting the diffracted light because, when the specimen has a pinhole, the inspection light passes through the pinhole and becomes diffracted as the diffracted light. In a configuration in which transmitted light is detected, by contrast, it is difficult to determine the presence of a pinhole, because the specimen has optical transmissivity and the transmitted light having transmitted through the pinhole is barely distinguishable from the transmitted light having transmitted through the specimen.

In the manner described above, because the inspection device according to the present invention can automatically inspect for both of contaminants and pinholes in a specimen, the time required for inspections for contaminants and inspections for pinholes can be reduced greatly, and the throughput can be improved.

In order to determine whether the contaminant attached to the specimen is on the front surface or the rear surface of the specimen, preferably, the light-emitting unit includes a first light-emitting unit that irradiates the one surface of the specimen with inspection light and a second light-emitting unit that irradiates the other surface of the specimen with inspection light; the scattered light detection unit includes a first scattered light detection unit disposed on a side of the one surface of the specimen and a second scattered light detection unit disposed on a side of the other surface of the specimen; and the signal processing unit determines whether the contaminant is attached to the front surface or the rear surface of the specimen on the basis of a first scattered light intensity signal from the first scattered light detection unit and a second scattered light intensity signal from the second scattered light detection unit.

As a specific embodiment of the diffracted light detection unit, the diffracted light detection unit may include a collecting optical system that is disposed offset from an optical axis of the inspection light and that collects the diffracted light, and a diffracted light detector for detecting the diffracted light collected by the collecting optical system.

With this configuration, because the collecting optical system is disposed offset from the optical axis of the inspection light having transmitted through the specimen, it is possible to prevent determination errors resultant of detecting the inspection light (transmitted light) having transmitted through the specimen.

As a specific embodiment of the collecting optical system, the collecting optical system may include a reflection mirror for changing an optical path of the diffracted light having been collected by the collecting mirror, and a light guide for converging the diffracted light having been reflected on the reflection mirror, to a light detection area of the diffracted light detector.

By using the reflection mirror to change the optical path of the collected diffracted light, a degree of freedom can be given to an optical arrangement of the collecting optical system. In this manner, it is possible to suppress physical interference with nearby equipment, and to reduce the size of the inspection device. In addition, because the light guide is provided, it is possible to guide the diffracted light having been collected into a linear shape to the diffracted light detector without much difficulty.

As a specific embodiment of the collecting optical system, preferably, the collecting optical system is for collecting first- or higher-order diffracted light. That is, the collecting optical system is disposed at a position where the first- or higher-order diffracted light can be collected.

As a specific embodiment of the light-emitting unit and the collecting optical system, preferably, the light-emitting unit includes a scanning optical system that scans the inspection light across the specimen in a predetermined direction, and the collecting optical system includes a collecting mirror having a cross-sectional shape that is constant along an axis that is parallel with a direction in which the inspection light is scanned. **In** this configuration, relative positions between the scanning optical system and the collecting mirror may be fixed, and the scanning optical system and the collecting mirror may be moved relatively with respect to the specimen in a direction intersecting with the scanning direction. The diffracted light collected by the collecting mirror having a constant cross-sectional shape forms a line.

In order to improve the efficiency at which the diffracted light is collected by the collecting mirror, the collecting mirror is preferably an elliptically cylindrical concave mirror.

In order to reduce the influence of the transmitted light having been transmitted through the specimen, the light-emitting unit preferably emits the inspection light at a wavelength exhibiting a transmittance of 40% or less through the specimen. Preferably, the wavelength of the inspection light exhibits a transmittance of 20% or less, more preferably 10% or less, through the specimen.

There is a possibility that the scattered light detection unit detects the inspection light having scattered on an edge of the pinhole or the like. Therefore, preferably, the scattered light detection unit includes a polarizing filter for transmitting scattered light from the contaminant but removing the scattered light from the pinhole, and a scattered light detector for detecting scattered light having transmitted through the polarizing filter.

As a specific embodiment of the determination made by the signal processing unit, preferably, the signal processing unit determines that there is the pinhole when the scattered light intensity signal is lower than a predetermined value and the diffracted light intensity signal is higher than or equal to a predetermined value; and determines that there is the contaminant when the scattered light intensity signal is higher than or equal to the predetermined value and the diffracted light intensity signal is lower than the predetermined value.

Preferably, the specimen is a pellicle such as an EUV pellicle. **In** exposure devices for manufacturing semiconductors, extreme ultraviolet (EUV) light sources have come to be used, as the semiconductor integrated circuits become miniaturized. Pellicles absorb this extreme ultraviolet (EUV) easily, and it is also more preferable for the film thickness of the pellicle to be smaller (e.g., about 50 nm). Therefore, EUV pellicles are highly likely to have pinholes having a size of about 1 µm, for example, and the inspection device of the present invention can be suitably used.

Furthermore, an inspection method according to the present invention includes: irradiating a specimen having a film-like shape and having optical transparency with inspection light; detecting scattered light from the specimen; detecting diffracted light from the specimen; and determining presence a contaminant attached to the specimen and presence a pinhole formed in the specimen on the basis of an intensity signal of the scattered light and an intensity signal of the diffracted light.

Furthermore, an inspection program according to the present invention is an inspection program used in an inspection device including: a light-emitting unit that irradiates a specimen having a film-like shape and having optical transparency with inspection light; a scattered light detection unit that is disposed on a same side of the specimen, as the side where the light-emitting unit is disposed, and that detects scattered light from the specimen; and a diffracted light detection unit that is disposed on a side of another surface of the specimen, the side being on an opposite side of where the light-emitting unit is disposed, and that detects diffracted light from the specimen, in which the inspection program providing a computer with a function for determining presence of a contaminant attached to the specimen and presence of a pinhole formed in the specimen, on the basis of a scattered light intensity signal from the scattered light detection unit and a diffracted light intensity signal from the diffracted light detection unit.

### Advantageous Effect of Invention

According to the present invention configured as described above, it is possible to determine the presence of a contaminant and the presence of a pinhole on a film-like specimen having optical transparency.

### Brief Description of Drawings

FIG. 1 is a schematic diagram illustrating an inspection device according to one embodiment of the present invention.
FIG. 2 is a perspective view schematically illustrating a diffracted light detection unit according to the embodiment.
FIG. 3 is a schematic diagram illustrating a method of determining a contaminant and a pinhole, according to the embodiment.
FIG. 4 is a schematic diagram illustrating a method of determining whether a contaminant is on a front surface or a rear surface, according to the embodiment. Description of Embodiment

### <One embodiment of present invention>

An inspection device according to one embodiment of the present invention will now be explained with reference to some drawings. Note that all of the drawings described below are schematic representations with some omissions and exaggerations made as appropriate, in order to facilitate understanding. The same elements are denoted by the same reference numerals, and the descriptions thereof will be omitted as appropriate.

An inspection device 100 according to the present embodiment inspects for a contaminant S attached to a film-like specimen W having optical transparency and a pinhole P formed in the specimen W.

In the description herein, the film-like specimen W having optical transparency is a protective film (pellicle) for preventing contaminants from becoming attached to a photomask in an exposure step, and, specifically, is a protective film (extreme ultraviolet (EUV) pellicle) for preventing contaminant from becoming attached to a photomask in an exposure step that uses an EUV light source. The protective film is not limited to the EUV pellicle, and may be another type of pellicle. In the description hereunder, a rear surface of the specimen W means a surface on the side of the photomask, and is a surface facing the pattern. A front surface of the specimen W, by contrast, means a surface facing the opposite side of the photomask, and is an outer surface.

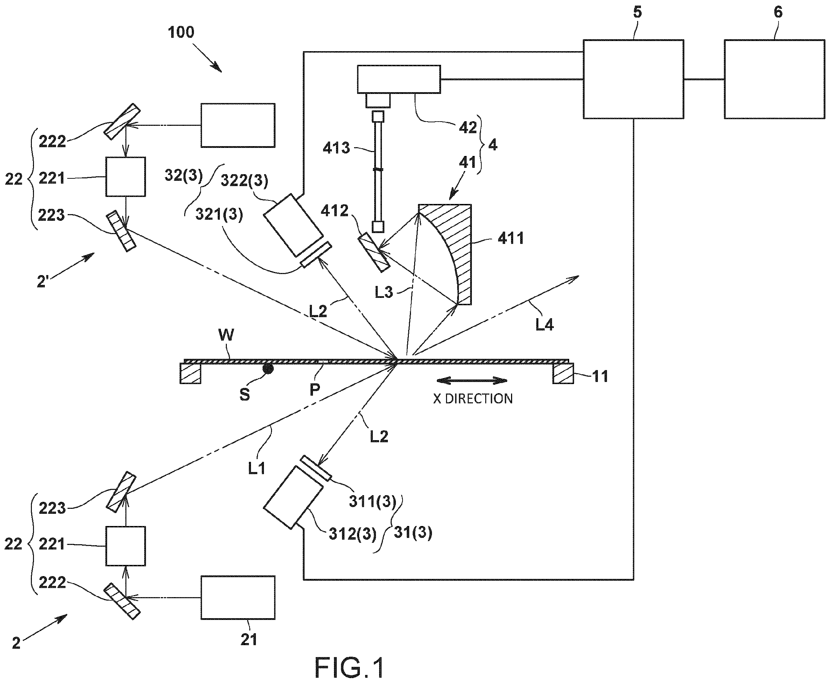

As illustrated in FIG. 1, the inspection device 100 according to the present embodiment includes a light-emitting unit 2 that irradiates the specimen W with the inspection light L1, a scattered light detection unit 3 that detects scattered light L2 resultant of irradiating the specimen W with the inspection light L1, a diffracted light detection unit 4 that detects diffracted light L3 resultant of irradiating the specimen W with the inspection light L1, and a signal processing unit 5 that determines the presence of the contaminant S attached to the specimen W and the presence of the pinhole P formed in the specimen W, on the basis of a scattered light intensity signal from the scattered light detection unit 3 and a diffracted light intensity signal from the diffracted light detection unit 4.

Note that the light-emitting unit 2, the scattered light detection unit 3, and the diffracted light detection unit 4 in the present embodiment are fixed to an inspection rack (not illustrated). The EUV pellicle, which is the specimen W, is fixed to a holding frame 11, and the holding frame 11 is enabled to be moved linearly along one direction (X direction in FIG. 1) with respect to the inspection rack, by a conveying mechanism (conveyor stage), not illustrated. The inspection rack therefore has a space for passing the specimen W, being passed by the conveying mechanism (conveyor stage).

The light-emitting unit 2 includes a first light-emitting unit 2 that irradiates one surface (in the example herein, the rear surface) of an EUV pellicle, which is a specimen W, with the inspection light L1, and a second light-emitting unit 2' that irradiates the other surface (in the example herein, the front surface) of the specimen W with the inspection light L1. The first light-emitting unit 2 and the second light-emitting unit 2' have the same configuration, and are different in that either the one surface or the other surface of the specimen W is irradiated with the inspection light L1 emitted therefrom.

The first light-emitting unit 2 will now be described representatively. Specifically, the first light-emitting unit 2 includes a laser light source 21 that emits a laser beam that is the inspection light L1, and a scanning optical system 22 that scans the laser beam L1 from the laser light source 21 across the specimen W in a predetermined direction. In the example herein, the predetermined direction is a direction (Y direction) orthogonal to the direction in which the specimen W is conveyed (X direction), on the horizontal plane. The first light-emitting unit 2 is provided at a position lower than the space where the specimen W is passed by the conveying mechanism, in the inspection rack.

The laser light source 21 emits a laser beam L1 having a wavelength exhibiting a transmittance of 40% or less through the specimen W. In the example herein, the laser beam L1 has has a wavelength exhibiting a transmittance of preferably 20% or less, more preferably 10% or less through the specimen W.

The scanning optical system 22 includes a scanning mirror (galvanometer mirror or polygon mirror) 221 that scans the laser beam L1 from the laser light source 21 in the Y direction. A guide mirror 222 may be provided between the laser light source 21 and the scanning mirror 221, or a guide mirror 223 may be provided on the side on which the light leaves the scanning mirror 221 (on the side of the specimen W), as necessary. With this scanning optical system 22, the laser beam L1 becomes incident on the rear surface of the specimen W.

The scattered light detection unit 3 is for detecting scattered light L2 resultant of irradiating the specimen W with the inspection light L1, and includes a first scattered light detection unit 31 disposed on the side of the rear surface of the specimen W and a second scattered light detection unit 32 disposed on the side of the front surface of the specimen W.

The first scattered light detection unit 31 is disposed on the one surface side of the specimen W, that is on the same side as where the first light-emitting unit 2 is disposed. Specifically, the first scattered light detection unit 31 includes a first polarizing filter 311 for transmitting the scattered light L2 from the contaminant S but removing the scattered light from the pinhole P, and a first scattered light detector 312 for detecting the scattered light L2 having transmitted through the polarizing filter 311. In the present embodiment, a photomultiplier tube (PMT) is used as the first scattered light detector 312, but a photodiode, a CCD camera, a CMOS image sensor, or the like may also be used. The first scattered light detection unit 31 is provided at a position lower than the space where the specimen W is passed by the conveying mechanism, in the inspection rack.

The second scattered light detection unit 32 is disposed on the other surface side of the specimen W, on the opposite side of where the first light-emitting unit 2 is disposed. Specifically, the second scattered light detection unit 32 includes a second polarizing filter 321 for transmitting the scattered light L2 from the contaminant S but removing the scattered light from the pinhole P, and a second scattered light detector 322 that detects the scattered light L2 having transmitted through the polarizing filter 321. In the present embodiment, a photomultiplier tube (PMT) is used as the second scattered light detector 322, but a photodiode, a CCD camera, a CMOS image sensor, or the like may also be used. The second scattered light detection unit 32 is provided at a position higher than the space where the specimen W is passed by the conveying mechanism, in the inspection rack.

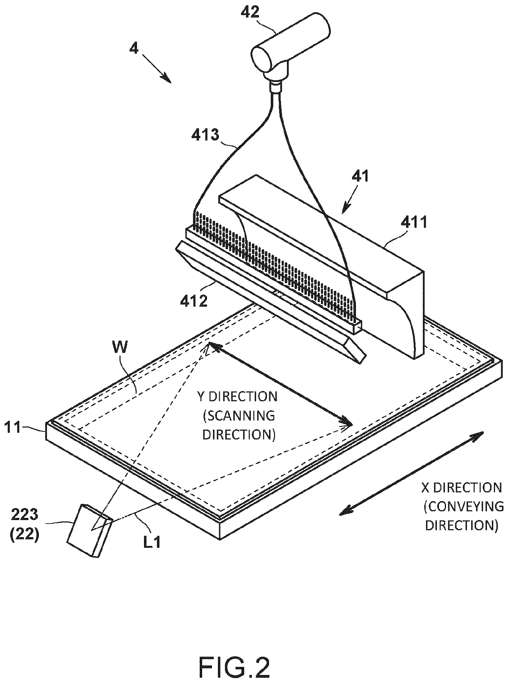

The diffracted light detection unit 4 is for detecting diffracted light L3 that is first- or higher-order diffracted light, and in the present embodiment, the diffracted light detection unit 4 is for detecting second-order diffracted light and third-order diffracted light. As illustrated in FIGS. 1 and 2, the diffracted light detection unit 4 is disposed on the opposite side of the light-emitting unit 2 with respect to the specimen W. Specifically, the diffracted light detection unit 4 is disposed offset from the light axis of the inspection light L1 (specifically, the optical path of the transmitted light L4 having transmitted through the specimen W), and includes a collecting optical system 41 for collecting the diffracted light L3, and a diffracted light detector 42 for detecting the diffracted light L3 collected by the collecting optical system 41. In the present embodiment, a photomultiplier tube (PMT) is used as the diffracted light detector 42, but a photodiode, a CCD camera, a CMOS image sensor, or the like may also be used. The diffracted light detection unit 4 is provided at a position higher than the space where the specimen W is passed by the conveying mechanism, in the inspection rack.

The collecting optical system 41 is for collecting the diffracted light L3 that is the first- or higher-order diffracted light (the second-order and the third-order diffracted light, in the present embodiment), and includes a collecting mirror 411 having a cross-sectional shape that is constant along an axis that is parallel with the direction in which the inspection light L1 is scanned (Y direction). The collecting mirror 411 is disposed at a position offset from the optical path of the transmitted light L4. The collecting mirror 411 in the present embodiment is an elliptically cylindrical concave mirror, and the cross section orthogonal to the Y direction is partial elliptic in shape, with a constant cross-sectional shape in the Y direction. It is preferable for the elliptically cylindrical concave mirror to be disposed in such a manner that one of the focal points of the ellipse of the elliptically cylindrical concave surface is positioned at the point of the specimen W irradiated with the laser beam L1. With such a collecting mirror 411, the diffracted light L3 becomes collected as a straight line, and forms linear light.

The collecting optical system 41 according to the present embodiment also includes a reflection mirror 412 for changing the optical path of the diffracted light L3 having been collected by the collecting mirror 411, and a light guide 413 for focusing the diffracted light L3 having been reflected by the reflection mirror 412 to a light detection area of the diffracted light detector 42.

In the description herein, the reflection mirror 412 is disposed in such a manner that the diffracted light L3 collected by the collecting mirror 411 is reflected upwards (in the description herein, vertically upwards). The reflection mirror 412 is disposed at or near the other focal position of the ellipse of the collecting mirror 411.

The light guide 413 includes a plurality of optical fibers. As illustrated in FIG. 2, on the incoming side of the light (the side of the reflection mirror 412), incoming ends of the plurality of optical fibers are arranged along a straight line. On the outgoing side of the light (the side of the diffracted light detector 42), outgoing ends of the plurality of optical fibers are bundled and arranged in a substantially circular shape. The light guide 413 extends vertically upwards and guides the diffracted light L3 to the diffracted light detector 42 provided above the reflection mirror 412.

By using the reflection mirror 412 and the light guide 413 to guide the diffracted light L3 collected with the collecting mirror 411 upwards in the manner described above, it is possible to ensure a space for installing other devices such as the second scattered light detection unit 32 in the inspection rack.

The signal processing unit 5 receives the light intensity signals from the first scattered light detector 312, the second scattered light detector 322, and the diffracted light detector 42, determines the presence of contaminant S attached to the specimen W and the presence of a pinhole P formed in the specimen W on the basis of the light intensity signals, and determines to which one of the front surface and the rear surface of the specimen W the contaminant S is attached.

The signal processing unit 5 is a computer including a CPU, a memory, an input/output interface, and an AD converter, and exhibits a function of inspecting for the presence of contaminant and a pinhole through a cooperation of the CPU and peripheral devices based on an inspection program stored in the memory.

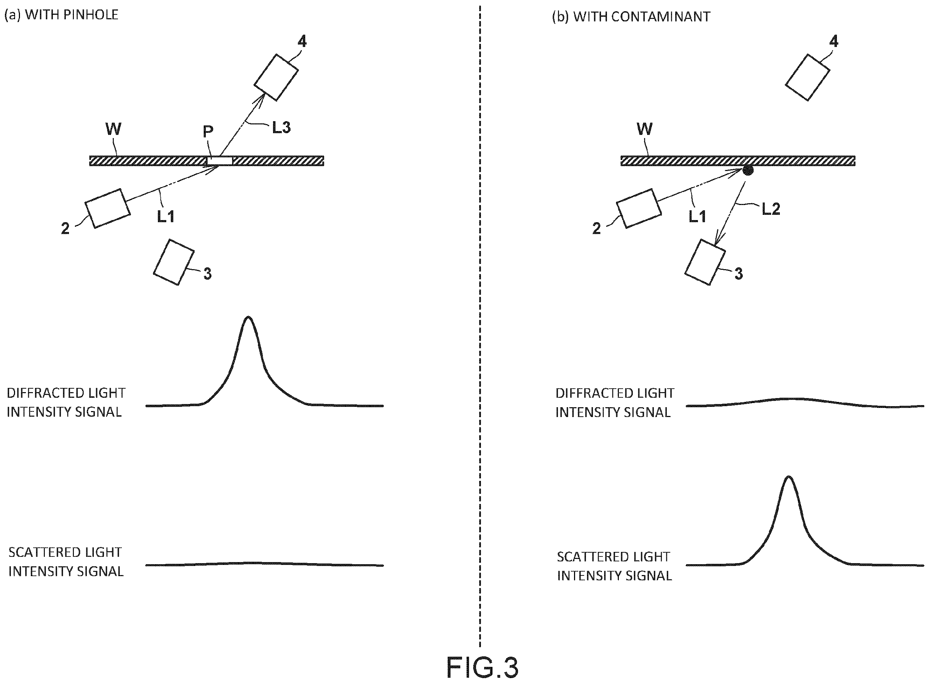

### <Determination of whether object is contaminant S or pinhole P (see FIG. 3)>

The signal processing unit 5 determines, by irradiating the rear surface with the inspection light L1, that there is a pinhole P when a scattered light intensity signal (one of the first scattered light intensity signal and the second scattered light intensity signal, the one being a signal the intensity of which is higher, in the example herein) is lower than a predetermined value and the diffracted light intensity signal is higher than or equal to the predetermined value. By contrast, the signal processing unit 5 determines that there is the contaminant S, by irradiating the rear surface with the inspection light L1, when the scattered light intensity signal (at least one of the first scattered light intensity signal and the second scattered light intensity in the example herein) is higher than or equal to the predetermined value and the diffracted light intensity signal is lower than the predetermined value. The predetermined value of the scattered light intensity signal and the predetermined value of the diffracted light intensity signal may be values that are different from each other. In this manner, the signal processing unit 5 determines whether a contaminant S is attached to the specimen W or a pinhole P is formed in the specimen W, on the basis of the scattered light intensity signal and the diffracted light intensity signal. When both of the scattered light intensity signal and the diffracted light intensity signal are lower than the respective predetermined values, it is determined that there is neither a contaminant nor a pinhole; and when both of the scattered light signal intensity and the diffracted light signal intensity are higher than or equal to the respective predetermined values, it is determined that there is a contaminant.

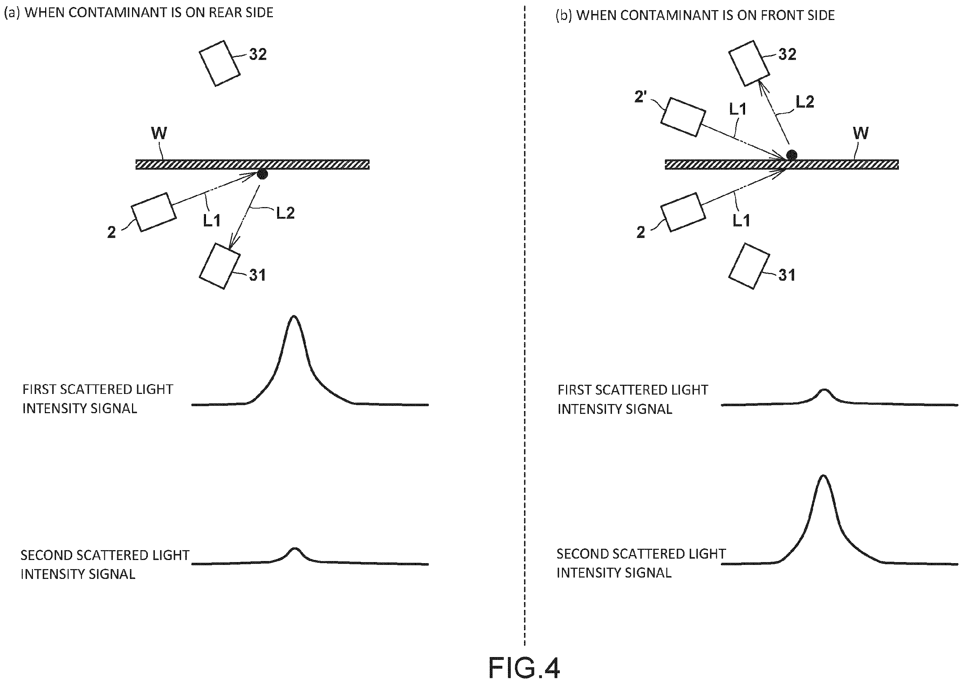

### <Determination of whether contaminant S is on front side or rear side (see FIG. 4)>

The signal processing unit 5 determines, by irradiating the rear surface with the inspection light L1 from the light-emitting unit 2, that the contaminant S is on the rear surface when the first scattered light intensity signal is higher than or equal to a predetermined value and the second scattered light intensity is lower than a predetermined value. The signal processing unit 5 determines, by contrast, by irradiating the front surface with the inspection light L1 emitted from the light-emitting unit 2' (having the same configuration as the light-emitting unit 2), that the contaminant S is on the front surface when the first scattered light intensity is lower than the predetermined value and the second scattered light intensity is higher than or equal to the predetermined value. The predetermined value of the first scattered light intensity signal and the predetermined value of the second scattered light intensity may be values that are different from each other. When both of the first scattered light intensity signal and the second scattered light intensity signal are lower than the respective predetermined values, it is determined that there is no contaminant; and when both of the first scattered light intensity signal and the second scattered light intensity signal are higher than or equal to the respective predetermined values, it is determined that there is a contaminant on the side on which the scattered light intensity is higher. In addition, when both of the first scattered light intensity signal and the second scattered light intensity signal saturate (saturation occurs), it is determined that the contaminant is on the side on which the integral of the signal exhibits a greater value (with a larger signal area).

Furthermore, using position information (X coordinate) acquired from the conveying mechanism (conveyor stage) and position information (Y coordinate) acquired from the scanning optical system (scanning mirror), the signal processing unit 5 can obtain the position information (X coordinate, Y coordinate) of the contaminant thus determined, and the position information (X coordinate, Y coordinate) of the pinhole thus determined. The signal processing unit 5 can then display the position information (X coordinate, Y coordinate) of the contaminant and the position information (X coordinate, Y coordinate) of the pinhole on a display unit 6 such as a display. As a mode of displaying the contaminant S on the display unit 6, it is conceivable to create selective mapping of contaminants, to create selective mapping of pinholes P, or to create mapping of both of contaminants S and pinholes P but in a manner allowing each to be identified.

### <Advantageous effects achieved by embodiment>

With the inspection device 100 according to the present embodiment configured as described above, it is possible to determine whether there is any contaminant S attached to the specimen W and there is any pinholes P on the specimen W automatically at once, on the basis of the scattered light intensity signals from the scattered light detection units 31, 32 and the diffracted light intensity signal from the diffracted light detection unit 4.

Specifically, the presence of the contaminant S can be determined by detecting the scattered light L2 because, when there is any contaminant S attached to the specimen W, the contaminant S is irradiated with the inspection light L1 and the inspection light L1 becomes scattered as the scattered light L2. The presence of a pinhole P can be determined by detecting the diffracted light L3 because, when the specimen W has a pinhole P, the inspection light L1 passes through the pinhole P and becomes diffracted as the diffracted light L3.

As described above, because the inspection device 100 according to the present embodiment can perform both of the contaminant inspection and the pinhole inspection of the specimen W automatically, the time required in detecting contaminants and pinholes can be greatly shortened, so that it is possible to improve the throughput.

### <Other embodiments>

The scattered light detection unit 3 may include only one of the first scattered light detection unit 31 and the second scattered light detection unit 32, for example. With such a configuration, it is possible for the signal processing unit 5 not to determine whether the contaminant S is on the front surface or the rear surface.

In the embodiment described above, because the configuration includes the first light-emitting unit 2 and the second light-emitting unit 2', the diffracted light detection unit 4 may be provided to the one surface side (rear surface side) of the specimen W, without limitation to the configuration in which the diffracted light detection unit 4 is provided on the other surface side (front surface side) of the specimen W. In the contaminant inspection device 100, the front and rear surfaces of the pellicle may be opposite to each other.

Furthermore, the polarizing filter in the scattered light detection unit 3 may be omitted.

Furthermore, although the collecting mirror 411 in the collecting optical system 41 has been described as an elliptically cylindrical concave mirror, it is possible for the collecting mirror to have another shape, or to use a collecting lens instead of the collecting mirror 411.

In addition, the collecting optical system 41 has been described to include the reflection mirror 412 and the light guide 413, but it is also possible to omit at least one of the reflection mirror 412 and the light guide. The light guide 413 is not limited to the configuration using optical fibers, and a light guide member such as a rod lens may also be used.

Each of the scattered light detection units according to the embodiment includes one scattered light detector, but each of the scattered light detection units may include a plurality of scattered light detectors. By providing a plurality of scattered light detectors and determining that there is contaminant when any one of the scattered light detectors detects the signal, the detection sensitivity can be improved, advantageously.

In the embodiment described above, contaminants and pinholes are distinguished from each other, but it is also possible to detect only pinholes using the configuration described below.

That is, a pinhole inspection device includes: a light-emitting unit that irradiates a specimen having a film-like shape and having optical transparency with inspection light; a diffracted light detection unit that is disposed on an opposite side of the light-emitting unit with respect to the specimen, and that detects diffracted light having diffracted on the specimen; and a signal processing unit that determines presence of a pinhole formed in the specimen on the basis of a diffracted light intensity signal from the diffracted light detection unit.

Any other various modifications and combinations of the embodiments are still possible within the scope not deviating from the gist of the present invention.

### Industrial Applicability

According to the present invention, it is possible to determine the presence of a contaminant and the presence of a pinhole on a film-like specimen having optical transparency, at once.

### Reference Signs List

- 100: contaminant inspection device
- W: specimen
- S: contaminant
- P: pinhole
- 2: light-emitting unit
- 21: scanning optical system
- L1: inspection light
- 3: scattered light detection unit
- L2: scattered light
- 31: first scattered light detection unit
- 32: second scattered light detection unit
- 311, 321: polarizing filter
- 312, 322: scattered light detector
- 4: diffracted light detection unit
- L3: diffracted light
- L4: transmitted light
- 41: collecting optical system
- 411: collecting mirror
- 412: reflection mirror
- 413: light guide
- 42: diffracted light detector
- 5: signal processing unit

## Claims

1. An inspection device comprising:
a light-emitting unit that irradiates one surface of a specimen having a film-like shape and having optical transparency with inspection light;
a scattered light detection unit that is disposed on a side of the one surface of the specimen, the side being a same side as where the light-emitting unit is disposed, and that detects scattered light from the specimen;
a diffracted light detection unit that is disposed on a side of another surface of the specimen, the side being on an opposite side of where the light-emitting unit is disposed, and that detects diffracted light from the specimen; and
a signal processing unit that determines presence of a contaminant attached to the specimen and presence of a pinhole formed in the specimen, based on a scattered light intensity signal from the scattered light detection unit and a diffracted light intensity signal from the diffracted light detection unit.

2. The inspection device according to claim 1, wherein
the light-emitting unit includes:
a first light-emitting unit that irradiates the one surface of the specimen with inspection light; and
a second light-emitting unit that irradiates the other surface of the specimen with the inspection light,
the scattered light detection unit includes:
a first scattered light detection unit disposed on the side of the one surface of the specimen; and
a second scattered light detection unit disposed on the side of the other surface of the specimen, and
the signal processing unit determines whether the contaminant is attached on a front surface or on a rear surface of the specimen based on a first scattered light intensity signal from the first scattered light detection unit and a second scattered light intensity signal from the second scattered light detection unit.

3. The inspection device according to claim 1 or 2, wherein the diffracted light detection unit includes:
a collecting optical system disposed at a position offset from an optical axis of the inspection light and that collects the diffracted light; and
a diffracted light detector that detects the diffracted light collected by the collecting optical system.

4. The inspection device according to claim 3, wherein the collecting optical system includes:
a reflection mirror for changing an optical path of the diffracted light having been collected by the collecting mirror; and
a light guide for converging the diffracted light having been reflected on the reflection mirror, to a light detection area of the diffracted light detector.

5. The inspection device according to claim 3 or 4, wherein
the light-emitting unit includes a scanning optical system that scans the inspection light across the specimen in a predetermined direction, and
the collecting optical system includes a collecting mirror having a cross-sectional shape that is constant along an axis that is parallel with a direction in which the inspection light is scanned.

6. The inspection device according to claim 5, wherein the collecting mirror is an elliptic cylindrical concave mirror.

7. The inspection device according to any one of claims 3 to 6, wherein the collecting optical system is for collecting first- or higher-order diffracted light.

8. The inspection device according to any one of claims 1 to 7, wherein the light-emitting unit emits inspection light having a wavelength exhibiting a transmittance of 40% or less through the specimen.

9. The inspection device according to any one of claims 1 to 8, wherein the scattered light detection unit includes:
a polarizing filter for transmitting scattered light from the contaminant but removing scattered light from the pinhole; and
a scattered light detector for detecting scattered light having transmitted through the polarizing filter.

10. The inspection device according to any one of claims 1 to 9, wherein the signal processing unit is configured to:
determine that the pinhole is present when the scattered light intensity signal is lower than a predetermined value and the diffracted light intensity signal is higher than or equal to a predetermined value, and
determine that the contaminant is present when the scattered light intensity signal is higher than or equal to the predetermined value and a diffracted light intensity signal is lower than the predetermined value.

11. The inspection device according to any one of claims 1 to 10, wherein the specimen is a pellicle.

12. An inspection method comprising:
irradiating a film-like specimen having optical transparency with inspection light;
detecting scattered light from the specimen;
detecting diffracted light from the specimen; and
determining presence a contaminant attached to the specimen and presence of a pinhole formed in the specimen based on an intensity signal of the scattered light and an intensity signal of the diffracted light.

13. An inspection program used in an inspection device including: a light-emitting unit that irradiates one surface of a specimen having a film-like shape and having optical transparency with inspection light; a scattered light detection unit that is disposed on a side of the one surface of the specimen, the side being a same side as where the light-emitting unit is disposed, and that detects scattered light from the specimen; and a diffracted light detection unit that is disposed on a side of another surface of the specimen, the side being on an opposite side of where the light-emitting unit is disposed, and that detects diffracted light from the specimen,
wherein the inspection program providing a computer with a function for determining presence of a contaminant attached to the specimen and presence of a pinhole formed in the specimen, based on a scattered light intensity signal from the scattered light detection unit and a diffracted light intensity signal from the diffracted light detection unit.
